(19) Europäisches Patentamt
European Patent Office
Office européen des brevets

(11) EP 3 640 734 A1

(12) EUROPEAN PATENT APPLICATION

(43) Date of publication:
22.04.2020 Bulletin 2020/17

(51) Int Cl.:
G03F 7/20 (2006.01)     G02B 5/02 (2006.01)

(21) Application number: 18200620.5

(22) Date of filing: 16.10.2018

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: ASML Netherlands B.V.
5500 AH Veldhoven (NL)

(72) Inventors:
• VAN DE KERKHOF, Marcus Adrianus
5500 AH Veldhoven (NL)
• VAN ZWOL, Pieter-Jan
5500 AH Veldhoven (NL)
• DE WINTER, Laurentius Cornelius
5500 AH Veldhoven (NL)

(74) Representative: Slenders, Petrus Johannes
Waltherus
ASML Netherlands B.V.
Corporate Intellectual Property
De Run 6501
P.O. Box 324
5500 AH  Veldhoven (NL)

(54) TRANSMISSIVE DIFFUSOR

(57) A first diffusor configured to receive and transmit radiation comprises a plurality of layers, each layer arranged to change an angular distribution of EUV radiation passing through it differently. A second diffusor configured to receive and transmit radiation comprises: a first layer and a second layer. The first layer is formed from a first material, the first layer comprising a nanostructure on at least one surface of the first layer. The second layer is formed from a second material adjacent to the at least one surface of the first layer such that the second layer also comprises a nanostructure. The second material has a refractive index that is different to a refractive index of the first layer. The diffusor first and second diffusors may be configured to receive and transmit EUV radiation.

FIG. 5A

EP 3 640 734 A1

## Description

FIELD

The present invention relates to transmissive diffusors, i.e. diffusors configured to receive and transmit radiation, the transmitted radiation having an altered angular distribution. The diffusors may be suitable for use with EUV radiation and may form part of a measurement system within an EUV lithography apparatus.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

It is known for lithographic apparatus to comprise measurement systems for determining one or more pupil function variations. Pupil function variations may comprise: relative phase variations within the pupil plane and/or relative intensity variations within the pupil plane. Such measurement systems typically comprise an object level patterning device (for example a diffraction grating or pinhole or the like); an illumination system; and an image level sensor apparatus. The illumination system is arranged to illuminate the patterning device with radiation. At least a portion of the radiation scattered by the patterning device is received by the projection system (whose properties are being measured) which is arranged to form an image of the patterning device on the image level sensor apparatus. It is desirable for such measurement systems that the entire entrance pupil of the projection system receives radiation from the patterning device. However, the illumination system is typically also used by a lithographic apparatus for forming a (diffraction limited) image of an object level reticle or mask on an image level substrate (e.g. a resist coated silicon wafer) wherein it may be desirable to only illuminate one or more discrete portions of the entrance pupil of the projection system.

It may be desirable to provide a mechanism whereby an angular distribution of an illumination beam that would otherwise illuminate one or more discrete portions of the entrance pupil of the projection system can be altered such that the entire entrance pupil of the projection system can receive radiation from the patterning device.

SUMMARY

According to a first aspect of the invention there is provided a diffusor configured to receive and transmit radiation, wherein the diffusor comprises: a plurality of layers, each layer arranged to change an angular distribution of radiation passing through it differently.

The diffusor may be configured to receive and transmit EUV radiation.

The diffusor according to the first aspect of the invention may, for example, form part of an EUV lithographic apparatus. For example, the diffusor may be used in, or form part of, a measurement system for determining an aberration map or a relative intensity map for a projection system. Advantageously, by providing a plurality of layers, each layer being arranged to change an angular distribution of EUV radiation passing through it differently, the diffusor provides an arrangement whereby an EUV radiation beam can be more efficiently diffused over a desired range of angles. In addition, the plurality of layers which change the angular distribution of the EUV radiation passing through it differently provides more control over the angular distribution of the radiation exiting the diffusor.

At least two of the plurality of layers may predominantly cause angular dispersion of EUV radiation passing through it in a single scattering direction in a plane of the diffusor, and the scattering directions of the at least two layers may be different.

The plane of the diffusor may be referred to generally as the x-y plane. A propagation direction of radiation through the diffusor may be generally perpendicular to the plane of the diffusor and may be referred to generally as the z-direction. In one example embodiment, the diffusor may comprise two layers: a first layer arranged to cause angular dispersion in the x-direction; and a second layer arranged to cause angular dispersion in the y-direction.

At least two of the plurality of layers may cause different amounts of angular dispersion of EUV radiation passing through them in their respective scattering directions.

Advantageously, this can allow the amount of dispersion to be tailored for a particular purpose.

For example, as previously discussed, the diffusor may be used in, or form part of, a measurement system for determining an aberration map or a relative intensity map for a projection system of a lithographic apparatus. In such a lithographic apparatus, an illumination system is typically used to illuminate an object level reticle or mask and a projection system is used to form a (diffraction limited) image of on an image level substrate (e.g. a resist coated silicon wafer). Typically the projection system may apply a reduction factor so as to form an image with features that are smaller than corresponding features on object level reticle or mask. In some systems, the projection system may have an anamorphic design whereby different reduction factors are applied in two orthogonal directions. With such a design, the numerical aperture may be represented by an ellipse in the entrance pupil of the projection system (as opposed to a circle). With such an anamorphic projection system it may be desirable to provide a diffusor with, for example, more diffusion in a direction that corresponds to a major axis of this ellipse and less diffusion in a direction that corresponds to a minor axis of this ellipse. This can be achieved by using two layers which each causes different amounts of angular dispersion of EUV radiation in their respective (mutually perpendicular) scattering directions.

At least one of the plurality of layers may comprise a layer of scattering material with a nanostructure provided on at least one surface thereof.

Such an arrangement is particularly advantageous for use with EUV radiation (which may, for example, have a wavelength of 13.5 nm) because such a nanostructure comprises features with a dimension that is comparable to, or smaller than, the wavelength of the radiation that it is desired to diffuse. Under these conditions, the scattering is in the Mie-scattering regime, and significant angular dispersion can be achieved.

The nanostructure may comprise features with a dimension in the range 2-10 nm.

Features of this size or smaller may result in an angular divergence for EUV radiation of order of 10°, for example or the order of 7°. For example, features of this size or smaller may result in the angular scattering distribution in at least one scattering direction having a width of 5° or greater. This may ensure that substantially the entire pupil plane is filled with radiation for a lithography apparatus having a projection system with a numerical aperture of the order of 0.08.

The diffusor may be configured such that the angular scattering distribution in at least one scattering direction has a width of 5° or greater.

It will be appreciated that as used here, width may mean the full width at half maximum (FWHM) of the angular scattering distribution.

The scattering material may have a refractive index n and the magnitude of (1-n) may be greater than a threshold value of 0.06.

It will be appreciated that the diffusor according to the first aspect of the invention is a transmissive diffusor for use with EUV radiation. Due to the strong absorption of EUV radiation by most materials, EUV optical systems typically comprise reflective optics (rather than refractive lenses) in vacuum. In general, in order to maximise the angular dispersion of the EUV radiation it is desirable to maximize the optical contrast between the material from which the scattering nanostructure is formed and vacuum, i.e. it is desirable to maximize the absolute value of (1-n).

In some embodiments, the magnitude of (1-n) is greater than a threshold value of 0.08. In some embodiments, the magnitude of (1-n) is greater than a threshold value of 0.1. In some embodiments, the magnitude of (1-n) is greater than a threshold value of 0.12.

The scattering material may have an extinction coefficient k for EUV radiation less than a threshold value of 0.04 nm$^{-1}$.

It will be appreciated that the diffusor according to the first aspect of the invention is a transmissive diffusor for use with EUV radiation. In general, in order to maximise the intensity of the EUV radiation which is output by the diffusor it is desirable to minimize the attenuation caused by the scattering material. This can be done by minimizing the extinction coefficient of the scattering material and/or minimizing the thickness of the scattering material.

In some embodiments, the magnitude of the extinction coefficient k for EUV radiation is less than a threshold value of 0.03 nm$^{-1}$. In some embodiments, the magnitude of the extinction coefficient k for EUV radiation is less than a threshold value of 0.02 nm$^{-1}$. In some embodiments, the magnitude of the extinction coefficient k for EUV radiation is less than a threshold value of 0.01 nm$^{-1}$.

It will be understood that, for a given scattering material, in order to increase the amount of angular dispersion it is desirable to increase the thickness of the layer(s) whereas in order to reduce the attenuation caused by the scattering material it is desirable to decrease the thickness of the layer(s). Having a scattering material for which the magnitude of (1-n) is large allows the thickness to be reduced (while still providing reasonable angular dispersion). Having a scattering material with a small extinction coefficient k for EUV radiation allows the thickness to be increased (while still providing reasonable transmission).

It will therefore be appreciated that, in practice, a suitable material may be selected balancing these two requirements.

In some embodiments, the magnitude of (1-n) is greater than a threshold value of 0.06 and the magnitude of the extinction coefficient k for EUV radiation is less than a threshold value of 0.01 nm$^{-1}$.

In some embodiments, the magnitude of (1-n) is greater than a threshold value of 0.08 and the magnitude of the extinction coefficient k for EUV radiation is less than a threshold value of 0.02 nm$^{-1}$.

In some embodiments, the magnitude of (1-n) is greater than a threshold value of 0.1 and the magnitude of the extinction coefficient k for EUV radiation is less than a threshold value of 0.03 nm$^{-1}$.

In some embodiments, the magnitude of (1-n) is greater than a threshold value of 0.12 and the magnitude of the extinction coefficient k for EUV radiation is less than a threshold value of 0.04 nm$^{-1}$.

The scattering material may have a refractive index n and an extinction coefficient k for EUV radiation and the ratio of the magnitude of (1-n) to (k+0.025) may be greater than a threshold value of 2.

The scattering material may comprise one of the following: molybdenum, ruthenium, niobium, rhodium or technetium.

The scattering material may have a thickness arranged to cause a phase shift of $(2m+1)\pi$ radians for EUV radiation propagating across the thickness of the scattering material. It will be appreciated that m is an integer.

Advantageously, this suppresses zero-order (or specular) scattering. It will be appreciated that the phase shift caused by propagating through the scattering material is $2\pi/\lambda$ multiplied by the change in optical path length that results from the scattering material, where $\lambda$ is the wavelength of the EUV radiation. If the scattering material is immersed in an optical medium having a refractive index of n2 then the change in optical path length that results from the scattering material is given by $(n-n_2)\cdot t$, where t is the thickness of the scattering material.

For example, for an embodiment wherein the scattering material comprises molybdenum (with a refractive index of approximately 0.92) in vacuum (i.e. $n_2$=1), a phase shift of $\pi$ radians may be achieved for EUV radiation with a wavelength of 13.5 nm if the thickness of the material is approximately 85 nm.

The layer of scattering material may be adjacent a layer of support material, and the support material may have a nanostructure provided on at least one surface thereof.

The support material may have a refractive index close to 1 for EUV radiation and a relatively low absorption coefficient for EUV radiation. For example, the first material may comprise silicon or carbon. Such materials may be considered to be relatively optically neutral for EUV radiation.

The layer of support material may comprise a membrane formed from carbon nanotubes.

The layer of support material may comprise porous silicon.

According to a second aspect of the invention there is provided a diffusor configured to receive and transmit radiation, wherein the diffusor comprises: a first layer formed from a first material, the first layer comprising a nanostructure on at least one surface of the first layer; and a second layer formed from a second material adjacent to the at least one surface of the first layer such that the second layer also comprises a nanostructure, the second material having a refractive index that is different to a refractive index of the first layer.

The diffusor may be configured to receive and transmit EUV radiation.

The diffusor according to the second aspect of the invention may, for example, form part of an EUV lithographic apparatus. For example, the diffusor may be used in, or form part of, a measurement system for determining an aberration map or a relative intensity map for a projection system. By forming the diffusor from two layers, the first layer (which may be referred to as a support layer) may be used to impart a nanostructure to the second layer (which may be referred to as a scattering layer).

Since the second material has a refractive index that is different to a refractive index of the first layer, the first layer may be formed from a material that is relatively optically neutral for EUV radiation (for example having a refractive index close to 1 for EUV radiation and a relatively low absorption coefficient for EUV radiation) whereas the second layer can be formed from a material with suitable optical properties so as to achieve a desired angular dispersion of EUV radiation passing therethrough. For example, the first material may comprise silicon or carbon. Such materials may be considered to be relatively optically neutral for EUV radiation.

Providing (via the second layer) a layer of material that causes scattering and has a nanostructure formed thereon is particularly advantageous for use with EUV radiation (which may, for example, have a wavelength of 13.5 nm) because such a nanostructure comprises features with a dimension that is comparable to, or smaller than, the wavelength of the radiation that it is desired to diffuse. Under these conditions, the scattering is in the Mie-scattering regime, and significant angular dispersion can be achieved.

It will be appreciated that although the second layer may be said to be adjacent to the at least one surface of the first layer, in general the second layer will extend at least partially into the first layer. In some embodiments, the second layer may extend, a least in some positions in a plane of the diffusor, through the entire first layer.

The nanostructure may comprise features with a dimension in the range 2-10 nm.

Features of this size or smaller may result in an angular divergence for EUV radiation of order of 10°, for example or the order of 7°. For example, features of this size or smaller may result in the angular scattering distribution in at least one scattering direction having a width of 5° or greater. This may ensure that substantially the entire pupil plane is filled with radiation for a lithography apparatus having a projection system with a numerical aperture of the order of 0.08.

The diffusor may be configured such that the angular scattering distribution in at least one scattering direction has a width of 5° or greater.

It will be appreciated that as used here, width may mean the full width at half maximum (FWHM) of the angular scattering distribution.

The first layer may comprise a membrane formed from carbon nanotubes.

The first layer may comprise porous silicon.

The first layer may comprise a support material which has been selectively etched to form the nanostructure. The support material may, for example, comprise silicon or porous silicon.

A layer of metal may be provided on parts of the support material which have not been selectively etched.

The layer of metal may comprise a self-assembled metal structure. The self-assembled metal structure may be formed from, for example, gold. The self-assembled metal structure may be formed by physical vapour deposition (PVD).

The second material may have a refractive index n and the magnitude of (1-n) may be greater than a threshold value of 0.06.

It will be appreciated that the diffusor according to the second aspect of the invention is a transmissive diffusor for use with EUV radiation. Due to the strong absorption of EUV radiation by most materials, EUV optical systems typically comprise reflective optics (rather than refractive lenses) in vacuum. In general, in order to maximise the angular dispersion of the EUV radiation it is desirable to maximize the optical contrast between the material from which the scattering nanostructure is formed and vacuum, i.e. it is desirable to maximize the absolute value of (1-n).

In some embodiments, the magnitude of (1-n) is greater than a threshold value of 0.08. In some embodiments, the magnitude of (1-n) is greater than a threshold value of 0.1. In some embodiments, the magnitude of (1-n) is greater than a threshold value of 0.12.

The second material may have an extinction coefficient k for EUV radiation less than a threshold value of 0.04 nm$^{-1}$.

It will be appreciated that the diffusor according to the second aspect of the invention is a transmissive diffusor for use with EUV radiation. In general, in order to maximise the intensity of the EUV radiation which is output by the diffusor it is desirable to minimize the attenuation caused by the second material (which may be referred to as the scattering material). This can be done by minimizing the extinction coefficient of the scattering material and/or minimizing the thickness of the scattering material.

In some embodiments, the magnitude of the extinction coefficient k for EUV radiation is less than a threshold value of 0.03 nm$^{-1}$. In some embodiments, the magnitude of the extinction coefficient k for EUV radiation is less than a threshold value of 0.02 nm$^{-1}$. In some embodiments, the magnitude of the extinction coefficient k for EUV radiation is less than a threshold value of 0.01 nm$^{-1}$.

It will be understood that, for a given scattering material, in order to increase the amount of angular dispersion it is desirable to increase the thickness of the layer(s) whereas in order to reduce the attenuation caused by the scattering material it is desirable to decrease the thickness of the layer(s). Having a scattering material for which the magnitude of (1-n) is large allows the thickness to be reduced (while still providing reasonable angular dispersion). Having a scattering material with a small extinction coefficient k for EUV radiation allows the thickness to be increased (while still providing reasonable transmission).

It will therefore be appreciated that, in practice, a suitable material may be selected balancing these two requirements.

In some embodiments, the magnitude of (1-n) is greater than a threshold value of 0.06 and the magnitude of the extinction coefficient k for EUV radiation is less than a threshold value of 0.01 nm$^{-1}$.

In some embodiments, the magnitude of (1-n) is greater than a threshold value of 0.08 and the magnitude of the extinction coefficient k for EUV radiation is less than a threshold value of 0.02 nm$^{-1}$.

In some embodiments, the magnitude of (1-n) is greater than a threshold value of 0.1 and the magnitude of the extinction coefficient k for EUV radiation is less than a threshold value of 0.03 nm$^{-1}$.

In some embodiments, the magnitude of (1-n) is greater than a threshold value of 0.12 and the magnitude of the extinction coefficient k for EUV radiation is less than a threshold value of 0.04 nm$^{-1}$.

The second material may have a refractive index n and an extinction coefficient k for EUV radiation and the ratio of the magnitude of (1-n) to (k+0.025) may be greater than a threshold value of 2.

The second material may comprise one of the following: molybdenum, ruthenium, niobium, rhodium or technetium.

The diffusor may have a thickness arranged to cause a phase shift of $(2m+1)\pi$ radians for EUV radiation propagating across the thickness of the diffusor. It will be appreciated that m is an integer.

Advantageously, this suppresses zero-order (or specular) scattering.

The phase shift caused by propagating through the diffusor may be predominantly caused by the scattering material.

It will be appreciated that the phase shift caused by propagating through the scattering material is $2\pi/\lambda$ multiplied by the change in optical path length that results from the scattering material, where $\lambda$ is the wavelength of the EUV radiation. If the scattering material is immersed in an optical medium having a refractive index of n2 then the change in optical path length that results from the scattering material is given by $(n-n_2)\cdot t$, where t is the thickness of the scattering material.

For example, for an embodiment wherein the scattering material comprises molybdenum (with a refractive index of approximately 0.92) in vacuum (i.e. n2=1), a phase shift of $\pi$ radians may be achieved for EUV radiation with a wavelength of 13.5 nm if the thickness of the material is approximately 85 nm.

A transmissivity of the diffusor according to the first or second aspects of the invention for EUV radiation may be greater than 50%.

According to a third aspect of the invention there is provided a measurement system for determining an aberration map or relative intensity map for a projection system comprising a diffusor according to the first or second aspects of the invention.

Such measurement systems typically comprise an object level patterning device (for example a diffraction grating or pinhole or the like); an illumination system; and an image level sensor apparatus. The illumination system is arranged to illuminate the patterning device with radiation. At least a portion of the radiation scattered by the patterning device is received by the projection system (whose properties are being measured) which is arranged to form an image of the patterning device on the image level sensor apparatus. It is desirable for such measurement systems that the entire entrance pupil of the projection system receives radiation from the patterning device. However, the illumination system is typically also used by a lithographic apparatus for forming a (diffraction limited) image of an object level reticle or mask on an image level substrate (e.g. a resist coated silicon wafer). This is the primary purpose of a lithographic apparatus and it is often desirable during such image formation exposures for the illumination mode to use a localized illumination mode. For example, it may be desirable to use a multipole (e.g. dipole or quadrupole) illumination mode, wherein in the pupil plane of the illumination system only a finite number (e.g. two or four) of discrete pole regions receive radiation.

When the lithographic apparatus is not exposing and the measurement system is measuring a pupil plane function (e.g. a relative phase or intensity map of the projection system) it may be possible to reconfigure the illumination system so as to fill the illumination system pupil plane (and therefore also fill the entrance pupil of the projection system). However, to do so (and to revert back to an exposure illumination mode before the next exposure) may take more time than is desired for such in-line measurements.

Therefore, the diffusor of the first or second aspect of the invention may be used, during such in-line measurements, to increase the angular spread of the radiation scattered from the object level patterning device so as to increase the proportion of the entrance pupil of the projection system which is filled with radiation.

The measurement system may comprise: a patterning device; an illumination system arranged to illuminate the patterning device with radiation; and a sensor apparatus; wherein the illumination system and patterning device may be configured such that the projection system receives at least a portion of the radiation scattered by the patterning device and the sensor apparatus may be configured such that the projection system projects the received radiation onto the sensor apparatus; and the diffusor may be operable to receive the radiation produced by the illumination system and to alter an angular distribution of the radiation before it illuminates the patterning device.

The diffusor may be moveable between at least: a first, operating position wherein the diffusor is at least partially disposed in a path of the radiation produced by the illumination system and is arranged to alter an angular distribution of the radiation before it illuminates the patterning device; and a second, stored position wherein the diffusor is disposed out of the path of the radiation produced by the illumination system.

According to a fourth aspect of the invention there is provided a lithographic apparatus comprising: the measurement system according to the third aspect of the invention; and a projection system configured to receive at least a portion of the radiation scattered by the patterning device and configured to project the received radiation onto the sensor apparatus.

The diffusor may be mounted on a patterning device masking blade of the lithographic apparatus, an edge of the patterning device masking blades defining a field region of the lithography apparatus.

According to a fifth aspect of the invention there is provided a method of forming a diffusor according to the second aspect of the invention, the method comprising: forming the first layer from the first material, the first layer comprising a nanostructure on at least one surface of the first layer; and forming the second layer from the second material on the at least one surface of the first layer.

Forming the first layer may comprise: providing a layer of support material; forming a self-assembled metal structure on a surface of the layer of support material; and selectively etching parts of the layer of support material that are not in contact with the self-assembled metal structure.

The support material may, for example, comprise silicon or porous silicon (pSi).

The self-assembled metal structure may be formed from, for example, gold. The self-assembled metal structure may be formed by physical vapour deposition (PVD). The self-assembly relies on the known and robust phenomenon that in first few nanometers of film deposition discrete metal islands are formed on the surface of the layer of the support material.

With this technique, high-aspect-ratio structures can be formed in the layer of support material having a lateral resolution (i.e. in the plane of the layer of the support material) of down to around 10 nm or less. Therefore, advantageously, a structure can be formed that can achieve an angular divergence for EUV radiation of order of 10°, for example or the order of 7°, whilst still having sufficient thickness of the second layer to achieve a phase shift of $\pi$ radians for EUV radiation.

The layer of support material may be formed on a carrier layer, which may act to support the layer of support material while the diffusor is being formed and the method may further comprise removing said carrier layer once the first and second layers have been formed.

The carrier layer may be formed from silicon nitride (SiN), porour silicon (pSi) or molybdenum silicide (MoSi). The carrier layer may, for example, be removed by etching.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;
- Figure 2 is a schematic illustration of a reflective marker;
- Figures 3A and 3B are schematic illustrations of a sensor apparatus;
- Figure 4A shows the intensity distribution for a dipole illumination mode of the lithographic apparatus shown in Figure 1;
- Figure 4B shows the intensity distribution for a quadrupole illumination mode of the lithographic apparatus shown in Figure 1;
- Figure 5A is a schematic cross sectional view of a diffusor according to a first embodiment of the present invention and which may form part of the lithographic system shown in Figure 1;
- Figure 5B is a schematic plan view of the diffusor shown in Figure 5A;
- Figure 6 shows a plot of an extinction coefficient k for EUV radiation against the magnitude of (1-n) for EUV radiation for some materials;
- Figure 7 shows the intensity distribution of scattered radiation as a function of the scattering angle in a scattering direction for a diffusor of the type shown in Figure 5A and 5B;
- Figure 8A is a schematic cross sectional view of a portion of an intermediate layer stack from which a diffusor according to a second embodiment of the present invention is formed;
- Figure 8B is a schematic plan view of a portion of the intermediate layer stack shown in Figure 8A;

  -- Figure 9 is a schematic cross sectional view of a portion of a second intermediate layer stack formed from the intermediate layer stack shown in Figures 8A and 8B by selectively etching a layer of support material in the intermediate layer stack;

- Figure 10 is a schematic cross sectional view of a portion of a third intermediate layer stack formed from the second intermediate layer stack shown in Figure 9 by forming a layer of scattering material on a modified layer of support material within the second intermediate layer stack; and
- Figure 11 is a schematic cross sectional view of a portion of the diffusor according to a second embodiment of the present invention formed from the third intermediate layer stack shown in Figure 10.

DETAILED DESCRIPTION

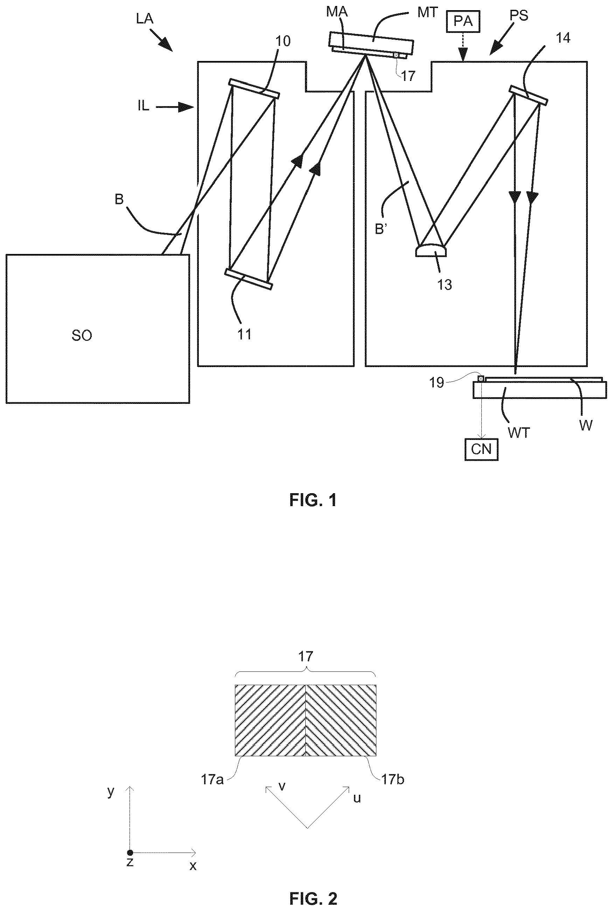

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The lithographic apparatus may, for example, be used in a scan mode, wherein the support structure (e.g. mask table) MT and the substrate table WT are scanned synchronously while a pattern imparted to the radiation beam is projected onto a substrate W (i.e. a dynamic exposure). The velocity and direction of the substrate table WT relative to the support structure (e.g. mask table) MT may be determined by the demagnification and image reversal characteristics of the projection system PS. The patterned radiation beam that is incident upon the substrate W may comprise a band of radiation. The band of radiation may be referred to as an exposure slit. During a scanning exposure, the movement of the substrate table WT and the support structure MT may be such that the exposure slit travels over an exposure field of the substrate W.

As has been described above, a lithographic apparatus may be used to expose portions of a substrate W in order to form a pattern in the substrate W. In order to improve the accuracy with which a desired pattern is transferred to a substrate W one or more properties of the lithographic apparatus LA may be measured. Such properties may be measured on a regular basis, for example before and/or after exposure of each substrate W, or may be measured more infrequently, for example, as part of a calibration process. Examples of properties of the lithographic apparatus LA which may be measured include a relative alignment of components of the lithographic apparatus LA and/or an aberration of components of the lithographic apparatus. For example, measurements may be made in order to determine the relative alignment of the support structure MT for supporting a patterning device MA and the substrate table WT for supporting a substrate W. Determining the relative alignment of the support structure MT and the substrate table WT assists in projecting a patterned radiation beam onto a desired portion of a substrate W. This may be particularly important when projecting patterned radiation onto a substrate W which includes portions which have already been exposed to radiation, so as to improve alignment of the patterned radiation with the previously exposed regions.

Additionally or alternatively measurements may be made in order to determine optical aberrations of the projection system PS. An optical aberration is a departure of the performance of an optical system from paraxial optics and may result in blurring or distortion of the pattern which is exposed at the substrate W. Aberrations of the projection system PS may be adjusted for and/or accounted for so as to increase the accuracy with which a desired pattern is formed on a substrate W.

Measurements, such as the alignment and aberration measurements described above may be performed by illuminating a reflective marker 17 (as schematically shown in Figure 1) with radiation. A marker is a reflective feature which when placed in the field of view of an optical system appears in an image produced by the optical system. Reflective markers described herein are suitable for use as a point of reference and/or for use as a measure of properties of the image formed by the optical system. For example, radiation reflected from a reflective marker may be used to determine an alignment of one or more components and/or optical aberrations of one or more components.

In the embodiment which is shown in Figure 1, the reflective marker 17 forms part of a patterning device MA. One or more markers 17 may be provided on patterning devices MA used to perform lithographic exposures. A marker 17 may be positioned outside of a patterned region of the patterning device MA, which is illuminated with radiation during a lithographic exposure. In some embodiments, one or more markers 17 may additionally or alternatively be provided on the support structure MT. For example, a dedicated piece of hardware, often referred to as a fiducial, may be provided on the support structure MT. A fiducial may include one or more markers. For the purposes of this description a fiducial is considered to be an example of a patterning device. In some embodiments, a patterning device MA specifically designed for measuring one or more properties of the lithographic apparatus LA may be placed on the support structure MT in order to perform a measurement process. The patterning device MA may include one or more markers 17 for illumination as part of a measurement process.

In the embodiment which is shown in Figure 1, the lithographic apparatus LA is an EUV lithographic apparatus and therefore uses a reflective patterning device MA. The marker 17 is thus a reflective marker 17. The configuration of a marker 17 may depend on the nature of the measurement which is to be made using the marker 17. A marker may, for example, comprise one or more reflective pin hole features comprising a reflective region surrounded by an absorbing region, a reflective line feature, an arrangement of a plurality of reflective line features and/or a reflective grating structure such as a reflective diffraction grating.

In order to measure one or more properties of the lithographic apparatus LA, a sensor apparatus 19 (as shown schematically in Figure 1) is provided to measure radiation which is output from the projection system PS. The sensor apparatus 19 may, for example, be provided on the substrate table WT as shown in Figure 1. In order to perform a measurement process, the support structure MT may be positioned such that the marker 17 on the patterning device MA is illuminated with radiation. The substrate table WT may be positioned such that radiation which is reflected from the marker is projected, by the projection system PS, onto the sensor apparatus 19. The sensor apparatus 19 is in communication with a controller CN which may determine one or more properties of the lithographic apparatus LA from the measurements made by the sensor apparatus 19. In some embodiments a plurality of markers 17 and/or sensor apparatuses 19 may be provided and properties of the lithographic apparatus LA may be measured at a plurality of different field points (i.e. locations in a field or object plane of the projection system PS).

As was described above, in some embodiments radiation reflected from a marker may be used to determine a relative alignment of components of the lithographic apparatus LA. In such embodiments, a marker 17 may comprise a feature which when illuminated with radiation imparts the radiation with an alignment feature. The feature may, for example, comprise one or more reflective patterns in the form of a grating structure.

The position of the alignment feature in the radiation beam B may be measured by a sensor apparatus 19 positioned at a substrate W level (e.g. on the substrate table WT as shown in Figure 1). The sensor apparatus 19 may be operable to detect the position of an alignment feature in the radiation incident upon it. This may allow the alignment of the substrate table WT relative to the marker on the pattering device MA to be determined. With knowledge of the relative alignment of the patterning device MA and the substrate table WT, the patterning device MA and the substrate table WT may be moved relative to each other so as to form a pattern (using the patterned radiation beam B reflected from the patterning device MA) at a desired location on the substrate W. The position of the substrate W on the substrate table may be determined using a separate measurement process.

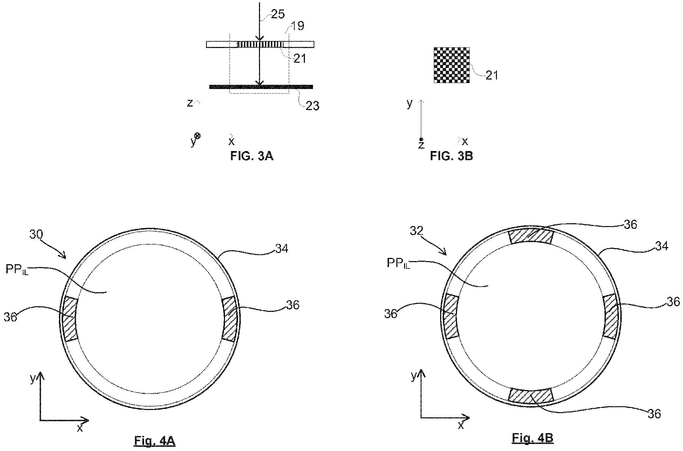

As was further described above, in some embodiments a patterning device MA may be provided with one or more markers 17 which may be used to measure aberrations of the projection system PS. Similarly to the alignment measurement described above, aberrations may be detected by measuring radiation reflected from a marker 17 with a sensor apparatus 19 located at or near to the substrate table WT. One or more markers 17 on a patterning device MA may be illuminated with EUV radiation, by the illumination system IL. Radiation reflected from the one or more markers is projected, by the projection system PS onto an image plane of the projection system PS. One or more sensor apparatuses 19 are positioned at or near to the image plane (e.g. on the substrate table WT as shown in Figure 1) and may measure the projected radiation in order to determine aberrations of the projection system PS. An embodiment of a marker 17 and a sensor apparatus 19 which may be used to determine aberrations of the projection system PS will now be described with reference to Figures 2 and 3.

Figure 2 is a schematic representation of a marker 17 which may form part of a patterning device MA according to an embodiment of the invention. Also shown in Figure 2 is a Cartesian coordinate system. The y-direction may represent a scanning direction of the lithographic apparatus. That is, during a scanning exposure, the movement of the substrate table WT and the support structure MT may be such that a patterning device MA is scanned relative to a substrate W in the y-direction. The marker 17 lies generally in an x-y plane. That is the marker generally extends in a direction which is perpendicular to the z-direction. Although reference is made to the marker lying generally in a plane, it will be appreciated that the marker is not entirely constrained to a plane. That is, portions of the marker may extend out of a plane in which the marker generally lies. As will be explained further below, a marker may comprise a diffraction grating. A diffraction grating may comprise a three-dimensional structure including portions which do not lie entirely in a plane but instead extend out of the plane.

The marker 17 which is shown in Figure 2 comprises a first portion 17a and a second portion 17b. Both the first and second portions comprise reflective diffraction gratings comprising a periodic grating structure. The grating structures extend in grating directions. The first portion 17a comprises a diffraction grating extending in a first grating direction which is denoted as the u-direction in Figure 2. The second portion 17b comprises a diffraction grating extending in a second grating direction which is denoted as the v-direction in Figure 2. In the embodiment of Figure 2, the u and v-directions are both aligned at approximately 45° relative to both the x and y-directions and are substantially perpendicular to each other. The first and second portions 17a, 17b of the marker 17 may be illuminated with radiation at the same or different times.

Whilst the embodiment which is shown in Figure 2 includes a first portion 17a and a second portion 17b comprising diffraction gratings orientated with perpendicular grating directions, in other embodiments a marker 17 may be provided in other forms. For example, a marker 17 may comprise reflective and absorbing regions arranged to form a checkerboard pattern. In some embodiments, a marker 17 may comprise an array of pinhole features. A reflective pinhole feature may comprise a region of reflective material surrounded by absorbing material.

When the first and/or second portions 17a, 17b of the marker are illuminated with radiation, a plurality of diffraction orders are reflected from the marker. At least a portion of the reflected diffraction orders enter the projection system PS. The projection system PS forms an image of the marker 17 on a sensor apparatus 19. Figures 3A and 3B are schematic illustrations of a sensor apparatus 19. Figure 3A is a side-on view of the sensor apparatus and Figure 3B is a top-down view of the sensor apparatus. Cartesian co-ordinates are also shown in Figures 3A and 3B.

The Cartesian co-ordinate system which is used in Figures 2, 3A and 3B is intended as a co-ordinate system of radiation propagating through the lithographic apparatus. At each reflective optical element, the z-direction is defined as the direction which is perpendicular to the optical element. That is, in Figure 2, the z-direction is perpendicular to an x-y plane in which the patterning device MA and the marker 17 generally extend. In Figures 3A and 3B, the z-direction is perpendicular to an x-y plane in which the diffraction grating 19 and the radiation sensor 23 generally extend. The y-direction denotes a scanning direction, in which the support structure MT and/or the substrate table WT are scanned relative to each other during a scanning exposure. The x-direction denotes a non-scanning direction which is perpendicular to the scanning direction. It will be appreciated (for example, from Figure 1) that, in a lithographic apparatus, the z-direction at the patterning device MA is not aligned with the z-direction at the substrate W. As explained above, the z-direction is defined at each optical element in the lithographic apparatus, as being perpendicular to the optical element.

The sensor apparatus 19 comprises a transmissive diffraction grating 21 and a radiation sensor 23. At least some of the radiation 25 which is output from the projection system PS passes through the diffraction grating 21 and is incident on the radiation sensor 23. The diffraction grating 21 is shown in more detail in Figure 3B and comprises a checkerboard diffraction grating. Regions of the diffraction grating 21 shown in Figure 3B which are shaded black represent regions of the diffraction grating 21 which are configured to be substantially opaque to incident radiation. Regions of the diffraction grating 21 shown in Figure 3B which are not shaded represent regions which are configured to transmit radiation. For ease of illustration, the opaque and transmissive regions of the diffraction grating 21 are not shown to scale in Figure 3B. For example, in practice the scale of the diffraction grating features, relative to the size of the diffraction grating itself may be smaller than is indicated in Figure 3B.

The diffraction grating 21 which is shown in Figure 3B is depicted as having a checkerboard configuration comprising square shaped transmissive and opaque regions. However, in practice it may be difficult or impossible to manufacture a transmissive diffraction grating comprising perfectly square shaped transmissive and opaque regions. The transmissive and/or opaque regions may therefore have cross-sectional shapes other than perfect squares. For example, the transmissive and/or opaque regions may have cross-sectional shapes comprising squares (or more generally rectangles) having rounded corners. In some embodiments, the transmissive and/or opaque regions may have cross-sectional shapes which are substantially circular or elliptical. In some embodiments, the diffraction grating 21 may comprise an array of pinholes formed in an opaque material.

The radiation sensor 23 is configured to detect the spatial intensity profile of radiation which is incident on the radiation detector 23. The radiation detector 23 may, for example, comprise an array of individual detector elements. For example, the radiation detector 23 may comprise a CCD or CMOS array. During a process for determining aberrations, the support structure MT may be positioned such that the marker 17 is illuminated with radiation from the illumination system IL. The substrate table WT may be positioned such that radiation reflected from the marker is projected by the projection system PS onto the sensor apparatus 19.

As was described above, a plurality of diffraction orders are formed at the marker 17. Further diffraction of radiation occurs at the diffraction grating 21. The interaction between diffraction orders formed at the marker 17 and diffraction patterns formed at the diffraction grating 21 results in an interference pattern being formed on the radiation detector 23. The interference pattern is related to the derivative of the phase of wavefronts which have propagated through the projection system. The interference pattern may therefore be used to determine aberrations of the projection system PS.

As was described above, the first and second portions of the marker 17 comprise diffraction gratings which are aligned perpendicular to each other. Radiation which is reflected from the first portion 17a of the marker 17 may provide information related to wavefronts in a first direction. Radiation which is reflected from the second portion 17b of the marker may provide information related to wavefronts in a second direction, which is perpendicular to the first direction. In some embodiments, the first and second portions of the marker may be illuminated at different times. For example, the first portion 17a of the marker 17 may be illuminated at a first time in order to derive information about wavefronts in the first direction and the second portion 17b of the marker 17 may be illuminated at a second time in order to derive information about wavefronts in the second direction.

In some embodiments, the patterning device MA and/or the sensor apparatus 19 may be sequentially scanned and/or stepped in two perpendicular directions. For example, the patterning device MA and/or the sensor apparatus 19 may be stepped relative to each other in the u and v-directions. The patterning device MA and/or the sensor apparatus 19 may be stepped in the u-direction whilst the second portion 17b of the marker 17 is illuminated and the patterning device MA and/or the sensor apparatus 19 may be stepped in the v-direction whilst the first portion 17a of the marker 17 is illuminated. That is, the patterning device MA and/or the sensor apparatus 19 may be stepped in a direction which is perpendicular to the grating direction of a diffraction grating which is being illuminated.

The patterning device MA and/or the sensor apparatus 19 may be stepped by distances which correspond with a fraction of the grating period of the diffraction gratings. Measurements which are made at different stepping positions may be analysed in order to derive information about a wavefront in the stepping direction. For example, the phase of the first harmonic of the measured signal may contain information about the derivative of a wavefront in the stepping direction. Stepping the patterning device MA and/or the sensor apparatus 19 in both the u and v-directions (which are perpendicular to each other) therefore allows information about a wavefront to be derived in two perpendicular directions, thereby allowing the full wavefront to be reconstructed.

In addition to stepping of the patterning device MA and/or the sensor apparatus 19 in a direction which is perpendicular to the grating direction of a diffraction grating which is being illuminated (as was described above), the patterning device MA and/or the sensor apparatus 19 may also be scanned relative to each other. Scanning of the patterning device MA and/or the sensor apparatus 19 may be performed in a direction which is parallel to the grating direction of a diffraction grating which is being illuminated. For example, the patterning device MA and/or the sensor apparatus 19 may be scanned in the u-direction whilst the first portion 17a of the marker 17 is illuminated and the patterning device MA and/or the sensor apparatus 19 may be scanned in the v-direction whilst the second portions 17a of the marker 17 is illuminated. Scanning of the patterning device MA and/or the sensor apparatus 19 in a direction which is parallel to the grating direction of a diffraction grating which is being illuminated allows measurements to be averaged out across the diffraction grating, thereby accounting for any variations in the diffraction grating in the scanning direction. Scanning of the patterning device MA and/or the sensor apparatus 19 may be performed at a different time to the stepping of the patterning device MA and/or the sensor apparatus 19 which was described above.

As was described above the diffraction grating 21 which forms part of the sensor apparatus 19 is configured in the form of a checkerboard. This may allow the sensor apparatus 19 to be used during a determination of wavefront phase variations in both the u-direction and the v-direction. The arrangements of diffraction gratings which form the marker 17 and the sensor apparatus 19 are presented merely as an example embodiment. It will be appreciated that a variety of different arrangements may be used in order to determine wavefront variations.

In some embodiments the marker 19 and/or the sensor apparatus 19 may comprise components other than a diffraction grating. For example, in some embodiments the marker 17 and/or the sensor apparatus 19 may comprise a single slit or one or more pin-hole feature through which at least a portion of a radiation beam may propagate. In the case of the marker 17, a pin-hole feature may comprise a portion of reflective material surrounded by absorbing material such that radiation is only reflected from a small portion of the marker. A single slit feature may have the form of a single strip of reflective material surrounded by absorbing material. A pin-hole feature and/or a single slit feature at the sensor apparatus 19, may be a transmissive feature. In general a marker 17 may be any feature which imparts a radiation beam with a feature, which may be used as a point of reference or to determine a measure of the radiation beam.

Whilst, in the embodiment described above a single marker 17 and sensor apparatus 19 is provided, in other embodiments a plurality of markers 17 and sensor apparatuses 19 may be provided in order to measure wavefront phase variations at different field points. In general any number and configuration of markers and sensor apparatuses 19 may be used to provide information about wavefront phase variations.

A controller CN (as shown in Figure 1) receives measurements made at the sensor apparatus 19 and determines, from the measurements, aberrations of the projection system PS. The controller may be further configured to control one or more components of the lithographic apparatus LA. For example, the controller CN may control a positioning apparatus which is operable to move the substrate table WT and/or the support structure MT relative to each other. The controller CN may control an adjusting means PA for adjusting components of the projection system PS. For example, the adjusting means PA may adjust elements of the projection system PS so as to correct for aberrations which are determined by the controller CN.

The projection system PS comprises a plurality of reflective lens elements 13, 14 and an adjusting means PA for adjusting the lens elements 13, 14 so as to correct for aberrations. To achieve this, the adjusting means PA may be operable to manipulate reflective lens elements within the projection system PS in one or more different ways. The adjusting means PA may be operable to do any combination of the following: displace one or more lens elements; tilt one or more lens elements; and/or deform one or more lens elements.

The projection system PS has an optical transfer function which may be nonuniform, which can affect the pattern which is imaged on the substrate W. For unpolarized radiation such effects can be fairly well described by two scalar maps, which describe the transmission (apodization) and relative phase (aberration) of radiation exiting the projection system PS as a function of position in a pupil plane thereof. These scalar maps, which may be referred to as the transmission map and the relative phase map, may be expressed as a linear combination of a complete set of basis functions. It will be appreciated that the terms "transmission map" and "relative intensity map" are synonymous and that the transmission map may alternatively be referred to as a relative intensity map. A particularly convenient set of basis functions for expressing these scalar maps is the Zernike polynomials, which form a set of orthogonal polynomials defined on a unit circle. A determination of each scalar map may involve determining the coefficients in such an expansion. Since the Zernike polynomials are orthogonal on the unit circle, the Zernike coefficients may be determined by calculating the inner product of a measured scalar map with each Zernike polynomial in turn and dividing this by the square of the norm of that Zernike polynomial.

The transmission map and the relative phase map are field and system dependent. That is, in general, each projection system PS will have a different Zernike expansion for each field point (i.e. for each spatial location in its image plane).

Determining aberrations of the projection system PS may comprise fitting the wavefront measurements which are made by the sensor apparatus 19 to Zernike polynomials in order to obtain Zernike coefficients. Different Zernike coefficients may provide information about different forms of aberration which are caused by the projection system PS. Zernike coefficients may be determined independently at different positions in the x and/or the y-directions (i.e. at different field points).

Different Zernike coefficients may provide information about different forms of aberration which are caused by the projection system PS. Typically Zernike polynomials are considered to comprise a plurality of orders, each order having an associated Zernike coefficient. The orders and coefficients may be labelled with an index, which is commonly referred to as a Noll index. The Zernike coefficient having a Noll index of 1 may be referred to as the first Zernike coefficient, the Zernike coefficient having a Noll index of 2 may be referred to as the second Zernike coefficient and so on.

The first Zernike coefficient relates to a mean value (which may be referred to as a piston) of a measured wavefront. The first Zernike coefficient may not be relevant to the performance of the projection system PS and as such may not be determined using the methods described herein. The second Zernike coefficient relates to the tilt of a measured wavefront in the x-direction. The tilt of a wavefront in the x-direction is equivalent to a placement in the x-direction. The third Zernike coefficient relates to the tilt of a measured wavefront in the y-direction. The tilt of a wavefront in the y-direction is equivalent to a placement in the y-direction. The fourth Zernike coefficient relates to a defocus of a measured wavefront. The fourth Zernike coefficient is equivalent to a placement in the z-direction. Higher order Zernike coefficients relate to other forms of aberration (e.g. astigmatism, coma, spherical aberrations and other effects).

Throughout this description the term "aberrations" is intended to include all forms of deviation of a wavefront from a perfect spherical wavefront. That is, the term "aberrations" may relate to the placement of an image (e.g. the second, third and fourth Zernike coefficients) and/or to higher order aberrations such as those which relate to Zernike coefficients having a Noll index of 5 or more.

As was described in detail above, one or more reflective markers 17 may be used to determine the alignment and or aberration of components of the lithographic apparatus LA. In some embodiments, separate markers 17 may be used for determining the alignment of components to markers used to determine aberrations. For example, a patterning device MA suitable for use in a lithographic exposure process may be provided with one or more markers outside of a patterned region suitable for use in a lithographic exposure process. The one or more markers may be suitable for determining the alignment of the patterning device MA relative to the substrate table WT.

One or more markers 17 suitable for determining aberrations may be provided on a measurement patterning device which is separate from patterning devices MA (e.g. reticles) used to perform lithographic exposures. A measurement patterning device MA may, for example, be positioned on the support structure MT for the purposes of performing aberration measurements. The measurement patterning device MA may include other features suitable for determining other properties of the projection system PS. For example, a measurement patterning device may additionally include a marker suitable for determining the alignment of the measurement patterning device relative to the substrate table WT.

In some embodiments, the same marker may be used to determine both alignment and aberrations. For example, both alignment and aberrations may be determined using one or more markers in the form of a reflective grating structure (e.g. a diffraction grating). In some embodiments, both alignment and aberrations may be determined simultaneously using the same set of measurements.

References herein to a patterning device MA should be interpreted to include any device including one or more features configured to modify radiation. A patterning device MA may, for example, be provided with a pattern for use during a lithographic exposure (for example, the patterning device may be a reticle). Additionally or alternatively a patterning device may be provided with one or more markers for use in a measurement process. In general, patterning devices MA are removable components which are placed on the support structure MT in order to perform a specific process (e.g. to perform a lithographic exposure and/or perform one or more measurement processes). However, in some embodiments a lithographic apparatus LA itself may be provided with one or more patterning features. For example, the support structure MT may be provided with one or more patterning features (e.g. markers) for use in a measurement process. For example, the support structure MT may be provided with one or more fiducials which include one or more markers. In such embodiments, the support structure MT itself may be considered to be an example of a patterning device, since it is provided with one or more features configured to modify radiation. References herein to a patterning device comprising a reflective marker should not be interpreted to be limited to removable patterning devices but should be interpreted to include any device having a reflective marker disposed thereon.

Referring to Figure 1, the pattering device MA may be considered to be disposed in an object plane of the projection system PS and the substrate W may be considered to be disposed in an image plane of the projection system PS. In the context of such a lithographic apparatus, the object plane of the projection system PL (where the patterning device MA is disposed), the image plane of the projection system PL (where the substrate W is disposed) and any planes conjugate thereto may be referred to as field planes of the lithographic apparatus. It will be appreciated that within an optical system (e.g. a lithographic apparatus) two planes are conjugate if each point within the first plane P is imaged onto a point in the second plane P'.

It will be appreciated that the lithographic apparatus LA comprises optics with optical power (i.e. focusing and/or diverging optics) in order to form an image in the image plane of an object in the object plane. Within such an optical system, between each pair of field planes it is possible to define a pupil plane which is a Fourier transform plane of a preceding field plane and a successive field plane. The distribution of the Electric field within each such pupil plane is related to a Fourier transform of an object disposed in a preceding field plane. It will be appreciated that the quality of such a pupil plane will depend on the optical design of the system and that such a pupil plane may even be curved. It is useful to consider two such pupil planes an illumination system pupil plane and a projection system pupil plane. The illumination system pupil plane and the projection system pupil plane (and any other pupil planes) are mutually conjugate planes. The intensity (or, equivalently, the electric field strength) distribution of radiation in the illumination system pupil plane $PP_{IL}$ may be referred to as the illumination mode or pupil fill and characterizes the angular distribution of the light cone at the patterning device MA (i.e. in the object plane). Similarly, the intensity (or, equivalently, the electric field strength) distribution of radiation in the projection system pupil plane $PP_{IL}$ characterizes the angular distribution of the light cone at the wafer level (i.e. in the image plane).

The illumination system IL may alter the intensity distribution of the beam in the illumination system pupil plane. This may be achieved by configuring the faceted field mirror device 10 and faceted pupil mirror device 11 appropriately.

During exposure of a substrate W the illumination system IL and the projection system PS are used to form a (diffraction limited) image of an object level patterning device MA on an image level substrate W (e.g. a resist coated silicon wafer). During such an exposure, it may be desirable for the illumination mode to use a localized illumination mode. For example, it may be desirable to use a multipole (e.g. dipole or quadrupole) illumination mode, wherein in the pupil plane of the illumination system $PP_{IL}$ only a finite number (e.g. two or four) of discrete pole regions receive radiation. Two examples of such illumination modes are shown in Figures 4A and 4B. For example, the illumination mode may be a dipole distribution 30 as shown in Figure 4A or a quadrupole distribution 32 as shown in Figure 4B. Also shown in Figures 4A and 4B is a circle 34 which represents the limit of what can physically be captured by the projection system PS and imaged onto the image plane (this represents the numerical aperture NA, or the sine of the maximum angle that can be captured by the projection system PS). In coordinates that are normalised by the numerical aperture NA of the projection system PS, circle 34 has a radius $\sigma=1$. The dipole distribution 30 comprises two diametrically opposed pole regions 36 where the intensity is non-zero. The quadrupole distribution 32 comprises a first dipole distribution similar to that shown in Figure 4A and a second dipole distribution rotated relative to the first by $\pi/2$ radians but otherwise identical to it. Therefore the quadrupole distribution 32 comprises four pole regions 34 where the intensity is non-zero.

When the lithographic apparatus is not exposing a substrate W, one of more reflective markers provided on a patterning device MA may be used in a measurement process, for example, to determine an alignment and/or aberrations associated with a lithographic apparatus LA. When using reflections from a marker to measure alignment and/or aberrations it may be desirable for the radiation reflected from the marker to fill a substantial portion of the pupil of the projection system PS. To achieve this, in principle, the illumination system IL may be reconfigured so as to fill the illumination system pupil plane (and therefore also fill the entrance pupil of the projection system). However, to do so (and to revert back to an exposure illumination mode before the next exposure) may take more time than is desired for such in-line measurements. Therefore, it is known to provide a diffusor during such measurements that is arranged to increase the angular spread of the radiation scattered from the object level patterning device so as to increase the proportion of the entrance pupil of the projection system PS which is filled with radiation.

Such a diffusor can be placed in a path of the radiation beam during these metrology measurements but not during exposure of a substrate W. This allows EUV lithographic apparatus to be operable to perform semi-continuous in-line metrology, which in turn can be used to maintain an optimum dynamic setup of the projection system PS, the support structure MT and the substrate table WT. In addition, such measurement systems may be used to align patterning devices MA to substrates W before exposure of the substrate W.

Some existing measurement systems use, at object level, a combined diffusor and patterning device (for example a one-dimensional diffraction grating). One arrangement uses a three-dimensional structure mounted on the support structure MT, comprising a recessed diffuser and a grating membrane that are disposed in two different planes. The EUV radiation beam B radiation beam exits the illumination system IL, reflects from the recessed diffusor (which increases the angular spread of the radiation) and then, after reflection, passes through the grating membrane (which scatters the radiation, some of the scattered radiation being captured by the projection system). Such a three-dimensional arrangement cannot be formed on a reticle and therefore is formed on a fiducial.

Another arrangement, as described in WO2017/207512, uses a reflective object that is a combined diffusor and patterning device. This arrangement is of the form of a multilayer reflective stack, arranged to preferentially reflect EUV radiation, to which is applied a pattern (for example a diffraction grating) of EUV absorbing material. The layers multilayer reflective stack are provided with a surface roughness such that the reflected radiation is diffuse. However, although such a patterning device can, in principle, be provided on a reticle, it is significantly more complex to manufacture a patterning device with such a built in surface roughness. Therefore, in practice, such a patterning device is more likely to be formed on a fiducial.

Embodiments of the present invention relate to novel diffusors that are particularly suitable for use with EUV measurement systems within EUV lithographic apparatus of the type discussed above.

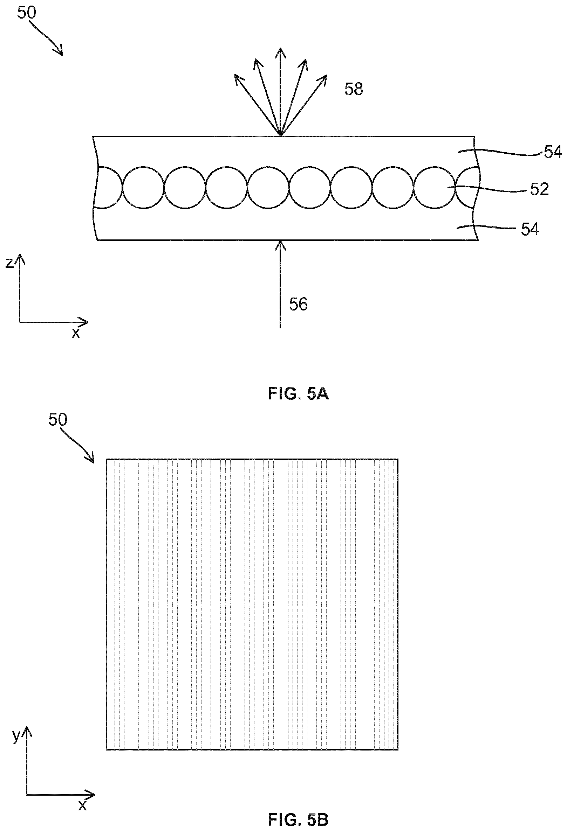

A diffusor 50 of according to a first embodiment of the present invention is shown schematically in Figures 5A and 5B. The diffusor 50 comprises a membrane formed from carbon nanotubes 52 and two layers of a scattering material 54 applied to two opposed surfaces of the carbon nanotube membrane 52. The carbon nanotube membrane 52 may be considered to form a layer of support material, which has nanostructure provided on the two opposed surfaces thereof.

The carbon nanotube membrane 52 has a refractive index close to 1 for EUV radiation and a relatively low absorption coefficient for EUV radiation. Therefore, the carbon nanotube membrane 52 may be considered to be relatively optically neutral for EUV radiation.

In contrast, the layers of scattering material 54 are formed from a material having suitable optical properties so as to cause a large angular dispersion for EUV radiation (whilst also having a reasonably large transmissivity for EUV radiation).

Accordingly, the layers of scattering material 54 are formed from a refractive index that is different to a refractive index of the carbon nanotube membrane 52. In particular, the scattering material may be formed from a material with refractive index n such that the magnitude of (1-n) is as large as possible. Additionally, the scattering material may be formed from a material having an extinction coefficient k for EUV radiation that is as small as possible.

It will be appreciated that the diffusor 50 is a transmissive diffusor for use with EUV radiation. In general, in order to maximise the intensity of the EUV radiation which is output by the diffusor 50 it is desirable to minimize the attenuation caused by the layers of scattering material 54. This can be done by minimizing the extinction coefficient of the scattering material and/or minimizing the thickness of the scattering material. Furthermore, it will be understood that, for a given scattering material, in order to increase the amount of angular dispersion it is desirable to increase the thickness of the layer(s) whereas in order to reduce the attenuation caused by the scattering material it is desirable to decrease the thickness of the layer(s). Having a scattering material with for which the magnitude of (1-n) is large allows the thickness to be reduced (while still providing reasonable angular dispersion). Having a scattering material with a small extinction coefficient k for EUV radiation allows the thickness to be increased (while still providing reasonable transmission).

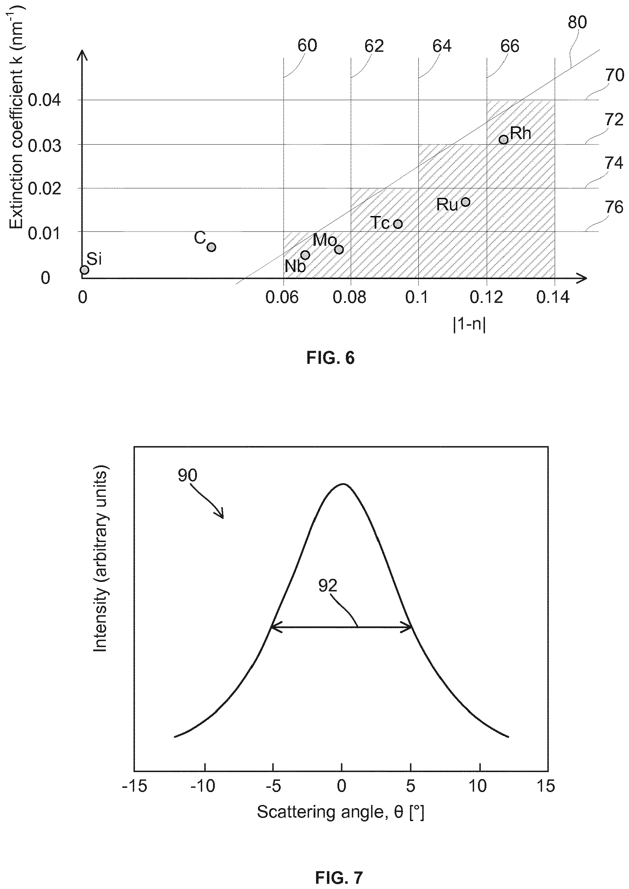

Suitable materials for the layers of scattering material 54 include: molybdenum, ruthenium or niobium. Figure 6 shows a plot of extinction coefficient k for EUV radiation against the magnitude of (1-n) for EUV radiation for these three materials and for carbon and silicon.

As already stated, it is desirable to maximise the magnitude of (1-n) of the scattering material for EUV radiation. In some embodiments, the magnitude of (1-n) of the scattering material for EUV radiation may be greater than a threshold value of 0.06 (i.e. to the right of line 60 in Figure 6). In some embodiments, the magnitude of (1-n) of the scattering material for EUV radiation may be greater than a threshold value of 0.08 (i.e. to the right of line 62 in Figure 6). In some embodiments, the magnitude of (1-n) of the scattering material for EUV radiation may be greater than a threshold value of 0.1 (i.e. to the right of line 64 in Figure 6). In some embodiments, the magnitude of (1-n) of the scattering material for EUV radiation may be greater than a threshold value of 0.12 (i.e. to the right of line 66 in Figure 6).

As already stated, it is desirable to minimise extinction coefficient k of the scattering material for EUV radiation. In some embodiments, the scattering material may have an extinction coefficient k for EUV radiation of less than a threshold value of 0.04 nm$^{-1}$ (i.e. below the line 70 in Figure 6). In some embodiments, the scattering material may have an extinction coefficient k for EUV radiation of less than a threshold value of 0.03 nm$^{-1}$ (i.e. below the line 72 in Figure 6). In some embodiments, the scattering material may have an extinction coefficient k for EUV radiation of less than a threshold value of 0.02 nm$^{-1}$ (i.e. below the line 74 in Figure 6). In some embodiments, the scattering material may have an extinction coefficient k for EUV radiation of less than a threshold value of 0.01 nm$^{-1}$ (i.e. below the line 76 in Figure 6).

It will be understood that, for a given scattering material, in order to increase the amount of angular dispersion it is desirable to increase the thickness of the layer(s) whereas in order to reduce the attenuation caused by the scattering material it is desirable to decrease the thickness of the layer(s). Having a scattering material for which the magnitude of (1-n) is large allows the thickness to be reduced (while still providing reasonable angular dispersion). Having a scattering material with a small extinction coefficient k for EUV radiation allows the thickness to be increased (while still providing reasonable transmission). It will therefore be appreciated that, in practice, a suitable material may be selected balancing these two requirements.

In some embodiments, the magnitude of (1-n) is greater than a threshold value of 0.06 and the magnitude of the extinction coefficient k for EUV radiation is less than a threshold value of 0.01 nm$^{-1}$; or the magnitude of (1-n) is greater than a threshold value of 0.08 and the magnitude of the extinction coefficient k for EUV radiation is less than a threshold value of 0.02 nm$^{-1}$; or the magnitude of (1 -n) is greater than a threshold value of 0.1 and the magnitude of the extinction coefficient k for EUV radiation is less than a threshold value of 0.03 nm$^{-1}$; or the magnitude of (1-n) is greater than a threshold value of 0.12 and the magnitude of the extinction coefficient k for EUV radiation is less than a threshold value of 0.04 nm$^{-1}$. That is, the material may be found in the cross hatched region of Figure 6.

In some embodiments, the magnitude of (1-n) and the extinction coefficient k for EUV radiation satisfy the following relationship:

$$\frac{|1 - n|}{(k + 0.025)} > 2 \qquad\qquad (1)$$

where |1-n| is the magnitude of (1-n). This is equivalent to being below the line 80 in Figure 6.

By forming the diffusor 50 from multiple layers, the carbon nanotube membrane 52 (which may be referred to as a support layer) may be used to impart a nanostructure to the layers 54 of scattering material (which may be referred to as a scattering layer).

Providing layers 54 of material that cause scattering and have a nanostructure formed thereon is particularly advantageous for use with EUV radiation (which may, for example, have a wavelength of 13.5 nm) because such a nanostructure comprises features with a dimension that is comparable to, or smaller than, the wavelength of the radiation that it is desired to diffuse. Under these conditions, the scattering is in the Mie-scattering regime, and significant angular dispersion can be achieved. For example, in some embodiments, the nanostructures formed in both the carbon nanotube membrane 52 and the layers of scattering material 54 comprise features with a dimension in the range 2-10 nm.

The carbon nanotube membrane 52 can be created in a variety of ways, either as a randomly oriented collection of nanotubes, or as a structured array of nanotubes. Especially the structured array type works well as a diffraction/scattering device: the nanotubes have typical diameters of 2-10nm, forming a grating structure with dimensions well below the EUV wavelength of 13.5nm. In the diffusor 50 shown in Figures 5A and 5B, the diffusor 50 is generally planar, lies generally in the x-y plane and the membrane 52 comprises a structured array of nanotubes which extend generally in the x direction. It will be appreciated that, as used herein, an object being described as being generally planar means that the dimensions of the object are significantly smaller in one dimension (the z direction in Figures 5A and 5B) than in the other two dimensions.

As shown rather schematically in Figure 5A, in use, radiation 56 is incident on the diffusor 50 propagating generally in the z direction. This incident radiation 56 may correspond to the radiation beam B output by the illumination system IL. It will be appreciated that the incident radiation may comprise radiation having a range of different angles of incidence and the arrow 56 shown in Figure 5A may represent the direction of a chief ray. The layers of scattering material 54 cause this incident radiation to be spread over a greater range of angles. This is indicated schematically by arrows 58.

In use, diffusor 50 may be used to increase the range of angles with which radiation reflected from an object level marker enters the projection system PS. In particular, it may be desirable for each part of the diffusor 50 to cause a divergence of the radiation 58 which is of the order of angular range of radiation accepted by a patterning device MA in the lithographic apparatus LA. For example, in one embodiment, the numerical aperture of the patterning device MA (and the projection system PS) in the lithographic apparatus may be of the order of 0.08, which corresponds to an angular range of approximately 7°. Therefore, it may be desirable for each lens formed by the second portion 105 to cause a divergence of the radiation 56 which is of the order of 7°. This may ensure that each field point on the patterning device MA receives radiation from substantially the whole range of angles within a cone with a full angular extent of the order of 7°. Equivalently, this may ensure that the patterning device is illuminated with a substantially full pupil fill.

Figure 7 shows the intensity distribution 90 of the scattered radiation 58 as a function of the scattering angle in a scattering direction of the diffusor 50 for an embodiment wherein the carbon nanotubes in the carbon nanotube membrane 52 have a diameter of around 10 nm and the layers 54 of scattering material comprise a 4 nm thickness of molybdenum. The carbon nanotube density of the carbon nanotube membrane 52 for this embodiment is around 50%. It can be seen from Figure 7 that it is possible for the width 92 of this angular distribution 90 (for example the full width at half maximum) to be of the order of 7°.

In some embodiments, the diffusor 50 may have a thickness (in the z-direction in Figures 5A and 5B) arranged to cause a phase shift of $(2m+1)\pi$ radians for EUV radiation 56 propagating across the thickness of the diffusor 50. Advantageously, this suppresses zero-order (or specular) scattering.

Since the carbon nanotube membrane 52 is relatively optically neutral for EUV radiation, the phase shift caused by propagating through the diffusor 50 may be predominantly caused by the layers of scattering material 54. It will be appreciated that the phase shift caused by propagating through the scattering material is $2\pi/\lambda$ multiplied by the change in optical path length that results from the scattering material, where $\lambda$ is the wavelength of the EUV radiation. If the scattering material is immersed in an optical medium having a refractive index of $n_2$ then the change in optical path length that results from the scattering material is given by $(n-n_2)\cdot t$, where t is the thickness of the scattering material.

For example, for an embodiment wherein the scattering material comprises molybdenum (with a refractive index of approximately 0.92) in vacuum (i.e. n2=1), a phase shift of $\pi$ radians may be achieved for EUV radiation with a wavelength of 13.5 nm if the thickness of the material is approximately 85 nm. If the molybdenum is formed on the carbon nanotube membrane 52 as a plurality of layers each having a thickness of around 8nm, a phase shift of approximately $\pi$ radians may be achieved having 10 layers. The transmission of such a structure for EUV radiation is >50%.

It will be appreciated that the diffusor 50 shown in Figures 5A and 5B forms a diffraction grating wherein the grating lines extend generally in the y-direction. Therefore, the diffusor 50 shown in Figures 5A and 5B predominantly causes angular dispersion of EUV radiation 56 passing through it in the x-direction (which may be referred to as the scattering direction of the diffusor 50 in a plane of the diffusor 50).

According to some embodiments of the present invention there are provided diffusors that comprise at least two diffusors 50 of the type shown in Figures 5A and 5B, the scattering directions of the at least two diffusors 50 being different.

For example, in one embodiment, the diffusor may comprise two diffusors 50 of the type shown in Figures 5A and 5B: a first diffusor 50 arranged to cause angular dispersion in the x-direction; and a second diffusor 50 arranged to cause angular dispersion in the y-direction.

By adding more diffusors 50 of the type shown in Figures 5A and 5B, each having a different scattering direction, scattering in all directions can be achieved. For example, additional diffusors 50 may be added with their scatting directions arranged at +45° and -45° to the x direction may be added. Additionally, additional diffusors 50 may be added with their scatting directions arranged at +30°, +60°, -30° and -60° to the x direction may be added and so on.

In this way, some embodiments of the present invention relate to diffusors that comprise a plurality of layers (each layer comprising, for example, a diffusor 50 of the type shown in Figures 5A and 5B), each layer arranged to change an angular distribution of EUV radiation passing through it differently. Advantageously, by providing a plurality of layers, each layer being arranged to change an angular distribution of EUV radiation passing through it differently, the diffusor provides an arrangement whereby an EUV radiation beam can be more efficiently diffused over a desired range of angles. In addition, the plurality of layers which change the angular distribution of the EUV radiation passing through it differently provides more control over the angular distribution of the radiation exiting the diffusor.

In some embodiments, the scattering properties of the individual layers (each being a diffusor 50 of the type shown in Figures 5A and 5B) can be individually tuned. This can be achieved, for example, by varying parameters of the carbon nanotube membranes 52 such as, for example, the carbon nanotube diameters and/or the carbon nanotube packing density. In this way, such multi-layer diffusors can be tailored to the entrance pupil of a projection system PS within the lithographic apparatus. For example, the scattering properties may be tuned so as to fill the entrance pupil of the projection system PS; to minimise gradients across the entrance pupil; and/or to minimize the amount of radiation that is scattered outside of the numerical aperture of the projection system PS.

For example, at least two of the plurality of layers of such a multi-layer diffusor can be arranged to cause different amounts of angular dispersion of EUV radiation passing through them in their respective scattering directions. Advantageously, this can allow the amount of dispersion to be tailored for a particular purpose. For example, the projection system PS of a lithographic apparatus LA may apply a reduction factor so as to form an image with features that are smaller than corresponding features on object level reticle or mask. In some systems, the projection system PS may have an anamorphic design whereby different reduction factors are applied in two orthogonal directions. With such a design, the numerical aperture may be represented by an ellipse in the entrance pupil of the projection system PS (as opposed to a circle). With such an anamorphic projection system PS it may be desirable to provide a diffusor with, for example, more diffusion in a direction that corresponds to a major axis of this ellipse and less diffusion in a direction that corresponds to a minor axis of this ellipse. This can be achieved by using two layers (each being a diffusor 50 of the type shown in Figures 5A and 5B) which each causes different amounts of angular dispersion of EUV radiation in their respective (mutually perpendicular) scattering directions.

Although in the above described embodiments, a support layer for the layers 54 of scattering material is provided by a carbon nanotube membrane, in alternative embodiments the support layer may comprise any material that is provided with a nanostructure. In some embodiments, the support layer may be formed from a material that is relatively optically neutral for EUV radiation (i.e. having a refractive index close to 1 for EUV radiation and a relatively low absorption coefficient for EUV radiation). In one embodiment, the support layer is alternatively provided by porous silicon.

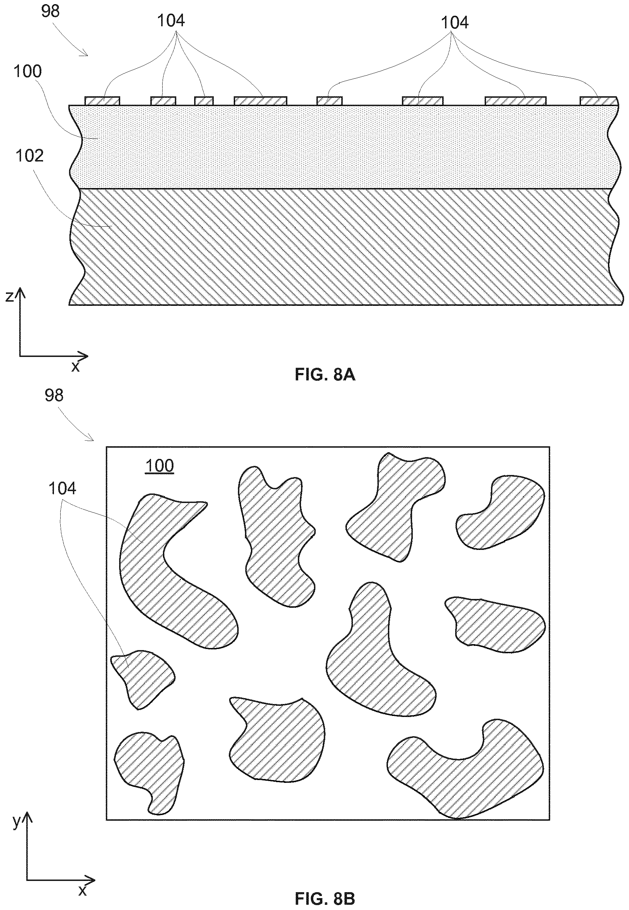

A diffusor of according to a second embodiment of the present invention, and a process for forming the same, is now discussed with reference to Figures 8A to 11.

The diffusor according to the second embodiment of the invention comprises a layer of support material comprising a nanostructure on at least one surface, the nanostructure having been formed by a self-assembled metal-assisted chemical etching of the support material. This layer of support material is coated with a scattering material. The formation of the nanostructure in the support material by a self-assembled metal-assisted chemical etching of the support material is now discussed with reference to Figures 8A to 9.

First, an intermediate layer stack 98 is formed. Figure 8A is a schematic cross sectional view of a portion of the intermediate layer stack 98 and Figure 8B is a schematic plan view of a portion of the intermediate layer stack 98.

The intermediate layer stack 98 comprises a layer of support material 100. The support material may, for example, comprise silicon or porous silicon (pSi). The layer of support material 100 may have a thickness of the order of 60 nm. In some embodiments, the support material is a material having a refractive index close to 1 for EUV radiation and a relatively low absorption coefficient for EUV radiation. For such embodiments, the support material may be considered to be relatively optically neutral for EUV radiation.

The layer of support material 100 is formed on a carrier layer 102, which may act to support the layer of support material 100 while the diffusor is being formed. The carrier layer 102 may be formed from silicon nitride (SiN), porour silicon (pSi) or molybdenum silicide (MoSi). The carrier layer 102 may, for example, have a thickness of the order of 100 nm.

The intermediate layer stack 98 further comprises a self-assembled metal structure, which is formed on a surface of the layer of support material 100. The self-assembled metal structure may be formed from, for example, gold. The self-assembled metal structure may be formed by physical vapour deposition (PVD). The self-assembly relies on the known and robust phenomenon that in first few nanometers of film deposition discrete metal islands 104 are formed on the surface of the layer of the support material 100 (see in particular Figure 8B). This is explained, for example, in X. Yu et al., "Coalescence and percolation in thin metal-films", Phys.Rev.B 44(23), 13163-13166 (1991), which is incorporated herein in its entirety by reference.

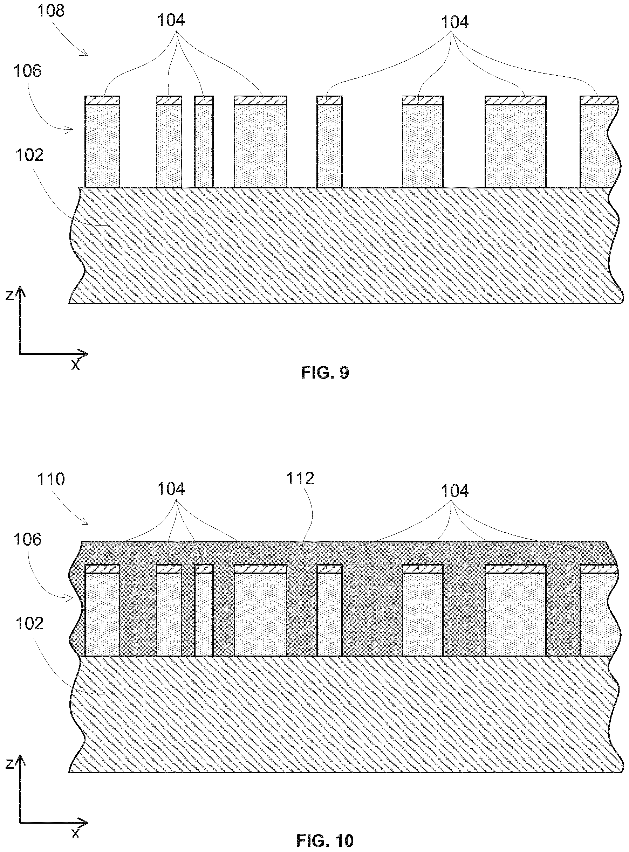

A second intermediate layer stack 108 is then formed from the intermediate layer stack 98, as now described with reference to Figure 9. The layer of support material 100 in the intermediate layer stack 98 is then selectively etched so as to form a modified layer of support material 106, as shown in cross-section in Figure 9. In effect, the discrete metal islands 104 mask those parts of the layer of support material 100 that they are in contact with from the etchant. This type of anisotropic catalytic etching of crystalline silicon in direct contact with such metal islands is also a known and robust process, which has been quite thoroughly investigated for several metals and etchants. This is described, for example, in J. Duran et al., "Fabrication of ultrahigh aspect ratio silicon nanostructures using self-assembled gold metal-assisted chemical etching", J. Micro/Nanolith. MEMS MOEMS 16(1), 014502 (2017), which is incorporated herein in its entirety by reference.

With this technique, high-aspect-ratio structures can be formed in the modified layer of support material 106 having a lateral resolution (i.e. in the plane of the layer of the support material 106, i.e. the x-y plane) of down to around 10 nm or less. The modified layer of support material 106 may therefore be considered to be a layer comprising a nanostructure on at least one surface thereof.

It will be appreciated that the layer of support material 100 in the intermediate layer stack 98 is selectively etched down to the interface between the layer of support material 100 and the carrier layer 102. In an alternative embodiment, an etch-stop layer may be provided between the layer of support material 100 and the carrier layer 102. For example, such an etch-stop layer may comprise a 2 nm layer of ruthenium. This may promote emissive cooling of the diffusor. Furthermore, by using an etch-stop layer may allow for a greater range of etchants to be used and may provide better control over the etching process.

A third intermediate layer stack 110 is then formed from the second intermediate layer stack 108, as now described with reference to Figure 10. As shown in cross-section in Figure 10, a layer of scattering material 112 is formed on the modified layer of support material 106. The layer of scattering material 112 may be considered to be adjacent to a surface of the modified layer of support material 106. As such, the layer of scattering material 112 also comprises a nanostructure. The layer of scattering material 112 may comprise a 5 nm coating of ruthenium.

In this embodiment, the discrete metal islands 104 are encapsulated between the layer of scattering material 112 and the modified layer of support material 106. This may aid in the radiative cooling of the diffusor. However, in an alternative embodiment, the discrete metal islands 104 may be removed after the etching and before the layer of scattering material 112 is formed on the modified layer of support material 106.

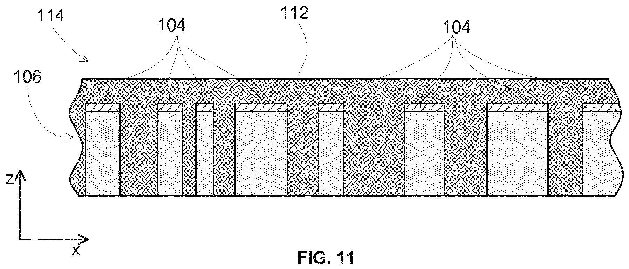

Finally, the carrier layer 102 is back-etched to form the diffusor 114 (see Figure 11).

With this technique, high-aspect-ratio structures can be formed in the modified layer of support material 106 and, in turn, in the layer of scattering material 112 having a lateral resolution (i.e. in the plane of the diffusor 114, i.e. the x-y plane) of down to around 10 nm or less. Such lateral resolution is well beyond what can be achieved by other means such as, for example, lithographic or e-beam patterning. As discussed above, providing such a layer of scattering material 112 that causes scattering and has a nanostructure formed thereon is particularly advantageous for use with EUV radiation (which may, for example, have a wavelength of 13.5 nm) because such a nanostructure comprises features with a dimension that is comparable to, or smaller than, the wavelength of the radiation that it is desired to diffuse. Under these conditions, the scattering is in the Mie-scattering regime, and significant angular dispersion can be achieved.

This order of lateral resolution of the structure formed in the layer of scattering material 112 allows the diffusor 114 to achieve scattering angles of >10°. Furthermore, the high aspect ratio allows a sufficient thickness of the layer of scattering material 112 to ensure sufficient phase effect for the diffuser 114. For example, as explained above, it may be desirable for the diffusor 114 to have a thickness (in the z-direction in Figure 11) arranged to cause a phase shift of

(2m+1)$\pi$ radians for EUV radiation propagating across the thickness of the diffusor 114. Advantageously, this suppresses zero-order (or specular) scattering.

If the scattering material is immersed in an optical medium having a refractive index of $n_2$ then the change in optical path length that results from the scattering material is given by $(n-n_2) \cdot t$, where t is the thickness of the scattering material. For example, for an embodiment wherein the scattering material comprises molybdenum (with a refractive index of approximately 0.92) in vacuum (i.e. n2=1), a phase shift of $\pi$ radians may be achieved for EUV radiation with a wavelength of 13.5 nm if the thickness of the material is approximately 85 nm.

It will be appreciated that the layer of support material 100 can be formed from any suitable material that is relatively optically neutral for EUV radiation and which can be etched to form the modified layer of support material 106. Suitable materials comprise silicon and porous silicon (pSi).

It will be appreciated that the layer of scattering material 112 is formed from a material having suitable optical properties so as to cause a large angular dispersion for EUV radiation (whilst also having a reasonably large transmissivity for EUV radiation). It will be appreciated that the layer of scattering material 112 may have any of the properties of the layers of scattering material 54 in the diffusor 50 shown in Figures 5A and 5B. Furthermore, the same considerations, as discussed above, that may be taken into account in the selection of a suitable material for the layers of scattering material 54 in the diffusor 50 shown in Figures 5A and 5B may also be taken into account when selecting of a suitable material for the layer of scattering material 112.

Accordingly, the layer of scattering material 112 may be formed from a material having a refractive index that is different to a refractive index of the layer of support material 100 (which may, for example, comprise silicon). In particular, the scattering material may be formed from a material with refractive index n such that the magnitude of (1-n) is as large as possible. Additionally, the scattering material may be formed from a material having an extinction coefficient k for EUV radiation that is as small as possible.

Suitable materials for the layer of scattering material 112 include: molybdenum, ruthenium or niobium. Figure 6 shows a plot of extinction coefficient k for EUV radiation against the magnitude of (1-n) for EUV radiation for these three materials and for carbon and silicon.

It will be appreciated that the diffusor 114 shown in Figure 11 forms a two-dimensional nanostructure. Therefore, the diffusor 14 shown in Figure 11 causes angular dispersion of EUV radiation passing through it both directions in the plane of the diffusor (i.e. in the x-direction and the y-direction).

According to some embodiments of the present invention, there is provided a measurement system for determining an aberration map or relative intensity map for a projection system PS comprising one of the above described diffusors. According to some embodiments of the present invention, there is provided a lithographic apparatus comprising such a measurement system.

In use, the diffusor (for example comprising at least one diffusor 50 of the type shown in Figures 5A and 5B or a diffusor 114 of the type shown in Figure 11) is disposed such that it can be moved into and out of the optical path of radiation between the illumination system IL and the projection system PS. Such an optical apparatus provides control over the angular distribution of radiation in field planes of the lithographic apparatus LA that are downstream of the apparatus. Such field planes include the plane of the support structure MT (i.e. the plane of a patterning device MA) and the plane of the substrate table WT (i.e. the plane of a substrate W). In order to ensure that the diffusor can be moved into and out of the optical path of radiation between the illumination system IL and the projection system PS, the diffusor may be mounted on a patterning device masking blade of the lithographic apparatus LA, as now discussed.

The lithographic apparatus LA is provided with four reticle masking blades, which define the extent of the field on the patterning device MA which is illuminated. The illumination system IL is operable to illuminate a generally rectangular region of an object disposed on the support structure MT (for example a patterning device MA). This generally rectangular region may be referred to as the slit of the illumination system IL and is defined by four reticle masking blades. The extent of the generally rectangular region in a first direction, which may be referred to as the x direction, is defined by a pair of x masking blades. The extent of the generally rectangular region in a second direction, which may be referred to as the y direction, is defined by a pair of y masking blades.

Each of the masking blades is disposed close to, but slightly out of the plane of the support structure MT. The x masking blades are disposed in a first plane and the y masking blades are disposed in a second plane.

Each of the masking blades defines one edge of a rectangular field region in the plane of the object which receives radiation. Each blade may be independently movable between a retracted position wherein it is not disposed in the path of the radiation beam and an inserted position wherein it at least partially blocks the radiation beam projected onto the object. By moving the masking blades into the path of the radiation beam, the radiation beam B can be truncated (in the x and/or y direction) thus limiting the extent of the field region which receives radiation beam B.

The x direction may correspond to a non-scanning direction of the lithographic apparatus LA and the y direction may correspond to a scanning direction of the lithographic apparatus LA. That is, the object (and a substrate W in the image plane) may be movable in the y-direction through the field region so as to expose a greater target region of the object (and the substrate W) in a single dynamic scanning exposure. During such a dynamic scanning exposure the y masking blades are moved to control the field region so as to ensure that no parts of the substrate W outside of a target region are exposed. At the start of the scanning exposure one of the y masking blades is disposed in the path of the radiation beam B, acting as a shutter, such that no part of the substrate W receives radiation. At the end of the scanning exposure the other y masking blade is disposed in the path of the radiation beam B, acting as a shutter, such that no part of the substrate W receives radiation.

The diffusor (for example comprising at least one diffusor 50 of the type shown in Figures 5A and 5B or a diffusor 114 of the type shown in Figure 11) may be mounted on a patterning device masking blade of the lithographic apparatus LA. In particular, the diffusor may be positioned such that it is not generally disposed in the path of the radiation beam when the masking blades are disposed in a position within their nominal movement ranges during a scanning exposure.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below. Other aspects of the invention are set-out as in the following numbered clauses.

1. A diffusor configured to receive and transmit radiation, wherein the diffusor comprises:
a plurality of layers, each layer arranged to change an angular distribution of radiation passing through it differently.

2. The diffusor of clause 1 wherein at least two of the plurality of layers predominantly cause angular dispersion of EUV radiation passing through it in a single scattering direction in a plane of the diffusor, the scattering directions of the at least two layers being different.

3. The diffusor of clause 2 wherein at least two of the plurality of layers causes different amounts of angular dispersion of EUV radiation passing through them in their respective scattering directions.

4. The diffusor of any preceding clause wherein at least one of the plurality of layers comprises a layer of scattering material with a nanostructure provided on at least one surface thereof.

5. The diffusor of clause 4 wherein the nanostructure comprises features with a dimension in the range 2-10 nm.

6. The diffusor of any preceding clause configured such that the angular scattering distribution in at least one scattering direction has a width of 5° or greater.

7. The diffusor of any one of clauses 4 to 6 wherein the scattering material has a refractive index n and wherein the magnitude of (1-n) is greater than a threshold value of 0.06.

8. The diffusor of any one of clauses 4 to 7 wherein the scattering material has an extinction coefficient k for EUV radiation less than a threshold value of 0.04 nm$^{-1}$.

9. The diffusor of any one of clauses 4 to 8 wherein the scattering material has a refractive index n and an extinction coefficient k for EUV radiation and wherein the ratio of the magnitude of (1-n) to (k+0.025) is greater than a threshold value of 2.

10. The diffusor of any one of clauses 4 to 9 wherein the scattering material comprises one of the following: molybdenum, ruthenium, niobium, rhodium or technetium.

11. The diffusor of any one of clauses 4 to 10 wherein the scattering material has a thickness arranged to cause a phase shift of $(2m+1)\pi$ radians for EUV radiation propagating across the thickness of the scattering material.

12. The diffusor of any one of clauses 4 to 11 wherein the layer of scattering material is adjacent a layer of support material, the support material having a nanostructure provided on at least one surface thereof.

13. The diffusor of clause 12 wherein the layer of support material comprises a membrane formed from carbon nanotubes.

14. The diffusor of clause 12 wherein the layer of support material comprises porous silicon.

15. A diffusor configured to receive and transmit radiation, wherein the diffusor comprises:

a first layer formed from a first material, the first layer comprising a nanostructure on at least one surface of the first layer; and
a second layer formed from a second material adjacent to the at least one surface of the first layer such that the second layer also comprises a nanostructure, the second material having a refractive index that is different to a refractive index of the first layer.

16. The diffusor of clause 15 wherein the nanostructure comprises features with a dimension in the range 2-10 nm.

17. The diffusor of clause 15 or clause 16 configured such that the angular scattering distribution in at least one scattering direction has a width of 5° or greater.

18. The diffusor of any one of clauses 15 to 17 wherein the first layer comprises a membrane formed from carbon nanotubes.

19. The diffusor of any one of clauses 15 to 17 wherein the first layer comprises porous silicon.

20. The diffusor of any one of clauses 15 to 17 wherein the first layer comprises a support material which has been selectively etched to form the nanostructure.

21. The diffusor of clause 20 wherein a layer of metal is provided on parts of the support material which have not been selectively etched.

22. The diffusor of any one of clauses 15 to 21 wherein the second material has a refractive index n and wherein the magnitude of (1-n) is greater than a threshold value of 0.06.

23. The diffusor of any one of clauses 15 to 22 wherein the second material has an extinction coefficient k for EUV radiation less than a threshold value of $0.04$ nm$^{-1}$.

24. The diffusor of any one of clauses 15 to 23 wherein the second material has a refractive index n and an extinction coefficient k for EUV radiation and wherein the ratio of the magnitude of (1-n) to (k+0.025) is greater than a threshold value of 2.

25. The diffusor of any one of clauses 15 to 24 wherein the second material comprises one of the following: molybdenum, ruthenium, niobium, rhodium or technetium.

26. The diffusor of any one of clauses 15 to 25 wherein the diffusor has a thickness arranged to cause a phase shift of $(2m+1)\pi$ radians for EUV radiation propagating across the thickness of the diffusor.

27. The diffusor of any preceding clause wherein a transmissivity of the diffusor for EUV radiation is greater than 50%.

28. A measurement system for determining an aberration map or relative intensity map for a projection system comprising the diffusor of any preceding clause.

29. The measurement system of clause 28, the measurement system comprising:

a patterning device;

an illumination system arranged to illuminate the patterning device with radiation; and

a sensor apparatus;

wherein the illumination system and patterning device are configured such that the projection system receives at least a portion of the radiation scattered by the patterning device and the sensor apparatus is configured such that the projection system projects the received radiation onto the sensor apparatus; and

wherein the diffusor is operable to receive the radiation produced by the illumination system and to alter an angular distribution of the radiation before it illuminates the patterning device.

30. The measurement system of clause 29 wherein the diffusor is moveable between at least:

a first, operating position wherein the diffusor is at least partially disposed in a path of the radiation produced by the illumination system and is arranged to alter an angular distribution of the radiation before it illuminates the patterning device; and

a second, stored position wherein the diffusor is disposed out of the path of the radiation produced by the illumination system.

31. A lithographic apparatus comprising:

the measurement system of any one of clauses 28 to 30; and

a projection system configured to receive at least a portion of the radiation scattered by the patterning device and configured to project the received radiation onto the sensor apparatus.

32. The lithography apparatus of clause 31 wherein the diffusor is mounted on a patterning device masking blade of the lithographic apparatus, an edge of the patterning device masking blades defining a field region of the lithography apparatus.

33. A method of forming a diffusor according to any one of clauses 15 to 27, the method comprising:

forming the first layer from the first material, the first layer comprising a nanostructure on at least one surface of the first layer; and

forming the second layer from the second material on the at least one surface of the first layer.

34. The method of clause 33 wherein forming the first layer comprises:

providing a layer of support material;
forming a self-assembled metal structure on a surface of the layer of support material; and
selectively etching parts of the layer of support material that are not in contact with the self-assembled metal structure.

35. The method of clause 34 wherein the layer of support material is formed on a carrier layer, which acts to support the layer of support material while the diffusor is being formed and wherein the method further comprises removing said carrier layer once the first and second layers have been formed.

**Claims**

1. A diffusor configured to receive and transmit radiation, wherein the diffusor comprises:
a plurality of layers, each layer arranged to change an angular distribution of radiation passing through it differently.

2. The diffusor of claim 1 wherein at least two of the plurality of layers predominantly cause angular dispersion of EUV radiation passing through it in a single scattering direction in a plane of the diffusor, the scattering directions of the at least two layers being different.

3. The diffusor of claim 2 wherein at least two of the plurality of layers causes different amounts of angular dispersion of EUV radiation passing through them in their respective scattering directions.

4. The diffusor of any preceding claim wherein at least one of the plurality of layers comprises a layer of scattering material with a nanostructure provided on at least one surface thereof.

5. The diffusor of claim 4 wherein the nanostructure comprises features with a dimension in the range 2-10 nm.

6. The diffusor of any preceding claim configured such that the angular scattering distribution in at least one scattering direction has a width of 5° or greater.

7. The diffusor of any one of claims 4 to 6 wherein the scattering material has a refractive index n and wherein the magnitude of (1-n) is greater than a threshold value of 0.06.

8. The diffusor of any one of claims 4 to 7 wherein the scattering material has an extinction coefficient k for EUV radiation less than a threshold value of 0.04 nm$^{-1}$.

9. The diffusor of any one of claims 4 to 8 wherein the scattering material has a refractive index n and an extinction coefficient k for EUV radiation and wherein the ratio of the magnitude of (1-n) to (k+0.025) is greater than a threshold value of 2.

10. The diffusor of any one of claims 4 to 9 wherein the scattering material comprises one of the following: molybdenum, ruthenium, niobium, rhodium or technetium.

11. The diffusor of any one of claims 4 to 10 wherein the scattering material has a thickness arranged to cause a phase shift of $(2m+1)\pi$ radians for EUV radiation propagating across the thickness of the scattering material.

12. The diffusor of any one of claims 4 to 11 wherein the layer of scattering material is adjacent a layer of support material, the support material having a nanostructure provided on at least one surface thereof.

13. The diffusor of claim 12 wherein the layer of support material comprises a membrane formed from carbon nanotubes.

14. The diffusor of claim 12 wherein the layer of support material comprises porous silicon.

15. A measurement system for determining an aberration map or relative intensity map for a projection system comprising the diffusor of any preceding claim.

16. The measurement system of claim 15, the measurement system comprising:

a patterning device;
an illumination system arranged to illuminate the patterning device with radiation; and
a sensor apparatus;
wherein the illumination system and patterning device are configured such that the projection system receives at least a portion of the radiation scattered by the patterning device and the sensor apparatus is configured such that the projection system projects the received radiation onto the sensor apparatus; and
wherein the diffusor is operable to receive the radiation produced by the illumination system and to alter an angular distribution of the radiation before it illuminates the patterning device.

17. The measurement system of claim 16 wherein the diffusor is moveable between at least:

a first, operating position wherein the diffusor is at least partially disposed in a path of the radiation produced by the illumination system and is arranged to alter an angular distribution of the radiation before it illuminates the patterning device; and
a second, stored position wherein the diffusor is disposed out of the path of the radiation produced by the illumination system.

**FIG. 1**

**FIG. 2**

FIG. 3A

FIG. 3B

Fig. 4A

Fig. 4B

**FIG. 5A**

**FIG. 5B**

FIG. 6

FIG. 7

FIG. 8A

FIG. 8B

108
104
104
106

102

Z

X

**FIG. 9**

110
104
112
104
106

102

Z

X

**FIG. 10**

FIG. 11

Europäisches
Patentamt

European
Patent Office

Office européen
des brevets

# EUROPEAN SEARCH REPORT

Application Number

EP 18 20 0620

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D<br><br>A | WO 2017/207512 A2 (ASML NETHERLANDS BV [NL]) 7 December 2017 (2017-12-07)<br>* paragraphs [0184] - [0191], [0196] - [0201]; figures 14, 16 *<br>----- | 1,4-11, 15-17<br><br>2,3, 12-14 | INV.<br>G03F7/20<br>G02B5/02 |
| A | US 2006/109533 A1 (SCHRIEVER MARTIN [DE] ET AL) 25 May 2006 (2006-05-25)<br>* paragraphs [0037] - [0039]; figures 2,3 *<br>----- | 1-17 | |
| A | VAN DE KERKHOF MARK ET AL: "Diffuser concepts for in-situ wavefront measurements of EUV projection optics", PROCEEDINGS OF SPIE; [PROCEEDINGS OF SPIE ISSN 0277-786X VOLUME 10524], SPIE, US, vol. 10583, 19 March 2018 (2018-03-19), pages 105830S-105830S, XP060103211, DOI: 10.1117/12.2297433 ISBN: 978-1-5106-1533-5 * section IV *<br>----- | 1-17 | |
| | | | TECHNICAL FIELDS SEARCHED (IPC)<br><br>G03F<br>G02B |

The present search report has been drawn up for all claims

| Place of search | Date of completion of the search | Examiner |
|---|---|---|
| Munich | 18 April 2019 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 18 20 0620

This annex lists the patent family members relating to the patent documents cited in the above-mentioned European search report.
The members are as contained in the European Patent Office EDP file on
The European Patent Office is in no way liable for these particulars which are merely given for the purpose of information.

18-04-2019

| Patent document cited in search report | | Publication date | Patent family member(s) | | Publication date |
|---|---|---|---|---|---|
| WO 2017207512 | A2 | 07-12-2017 | CN | 109196420 A | 11-01-2019 |
| | | | NL | 2018989 A | 05-12-2017 |
| | | | WO | 2017207512 A2 | 07-12-2017 |
| US 2006109533 | A1 | 25-05-2006 | AU | 2003281995 A1 | 01-11-2004 |
| | | | US | 2006109533 A1 | 25-05-2006 |
| | | | WO | 2004090490 A1 | 21-10-2004 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017207512 A

**Non-patent literature cited in the description**

- **X. YU et al.** Coalescence and percolation in thin metal-films. *Phys.Rev.B,* 1991, vol. 44 (23), 13163-13166

- **J. DURAN et al.** Fabrication of ultrahigh aspect ratio silicon nanostructures using self-assembled gold metal-assisted chemical etching. *J. Micro/Nanolith. MEMS MOEMS,* 2017, vol. 16 (1), 014502